# FASCICULE DE BREVET EUROPEEN

(11) **EP 1 017 101 B1**
(45) Date de publication et mention de la délivrance du brevet: **29.07.2009**
(21) Numéro de dépôt: 99204399.2
(22) Date de dépôt: 20.12.1999
(51) Int. Cl.: H01L 27/06, H01L 27/08, H01L 21/02, H01L 21/768

(54) **Circuit intégré incluant un réseau capacitif à faible dispersion**
Integrierter Schaltkreis mit einem Kapazitätsnetzwerk mit niedriger Dispersion
Integrated circuit comprising a capacitive network with low dispersion

(30) Priorité: 29.12.1998 FR 9816565
(43) Date de publication de la demande: 05.07.2000
(73) Titulaire: NXP B.V., 5656 AG Eindhoven (NL)
(72) Inventeur: Jovenin, Fabrice, 75008 Paris (FR); Butaye, Benoît, 75008 Paris (FR)
(74) Mandataire: Zapalowicz, Francis

(56) Documents cités:
- EP-A- 0 772 246
- EP-A- 0 836 271
- WO-A-96/07197
- US-A- 4 003 009
- US-A- 4 685 197
- US-A- 5 583 359
- US-A- 5 798 559
- PATENT ABSTRACTS OF JAPAN vol. 016, no. 059 (E-1166), 14 février 1992 (1992-02-14) -& JP 03 257855 A (MATSUSHITA ELECTRON CORP), 18 novembre 1991 (1991-11-18)

## Description

La présente invention concerne un circuit intégré comprenant une succession de couches formées de matériaux faiblement résistifs, dites couches conductrices, séparées deux à deux par des couches de matériau isolant, dites couches isolantes, circuit intégré incluant un premier élément capacitif présentant entre une première et une deuxième borne une capacité de valeur fixe, ledit élément capacitif étant constitué d'un empilement de plaques conductrices, découpées au sein des couches conductrices et électriquement isolées desdites couches.

Le brevet américain No. 4,685,197 décrit un circuit intégré incluant un élément capacitif constitué de deux couches conductrices séparées par une couche isolante et mentionne, sans en décrire de mode de réalisation, la possibilité d'utiliser plus de deux couches conductrices pour augmenter la valeur de la capacité d'un tel élément capacitif. La présente invention est liée aux considérations suivantes:
La réalisation d'un tel élément capacitif sous forme intégrée fait intervenir une succession d'étapes de fabrication, dont le nombre est fonction du nombre de couches conductrices incluses dans l'élément capacitif. Or, chaque étape de fabrication introduit dans le circuit intégré des imperfections qui provoquent un écart de la valeur réelle de la capacité de l'élément capacitif par rapport à sa valeur nominale.
Au cours d'une production en série, il peut arriver qu'une même étape de fabrication introduise des écarts dont les valeurs diffèrent d'un circuit intégré à un autre. L'ampleur de ces différences est appelée dispersion. De telles différences introduisent une incertitude sur les valeurs réelles des capacités des éléments capacitifs inclus dans les circuits intégrés ainsi produits, valeurs qui peuvent varier fortement d'un circuit intégré à l'autre. Cette incertitude s'avère très néfaste lorsque ces circuits intégrés sont destinés à des applications où la valeur réelle de la capacité qu'ils contiennent doit être connue de manière précise.
Une mesure systématique de la valeur réelle de la capacité incluse dans chaque circuit intégré en sortie de production est à proscrire, car difficile et coûteuse à mettre en oeuvre de manière répétitive. De plus, la détection d'un écart trop grand par rapport à la valeur nominale ne conduira qu'à la mise au rebut du circuit intégré ainsi identifié, ce qui fera chuter le rendement de production. Il est donc préférable de réduire la dispersion de manière préventive, au moyen d'une conception adéquate du circuit intégré. US 5 583 359 décrit un circuit intégré constitué des couches formant plusieurs éléments capacitifs en parallèle; EP 772246 décrit un condensateur à grande capacité. L'invention est definie par la revendication 1

La présente invention a pour but de remédier aux inconvénients décrits ci-dessus en proposant un circuit intégré incluant un élément capacitif dont la valeur réelle est plus facilement prédictible et moins vulnérable aux influences isolées de chacune des étapes de fabrication dudit circuit.

La construction du premier élément capacitif inclus dans le circuit intégré conforme à l'invention fait intervenir le plus grand nombre possible d'étapes de fabrication, puisque toutes les couches conductrices y sont présentes. Ceci implique que l'influence relative de chacune de ces étapes de fabrication sur la valeur réelle de la capacité ainsi produite est réduite au maximum. Ainsi, l'ampleur des différences d'un circuit à l'autre entre les écarts de la valeur réelle de la capacité par rapport à sa valeur nominale, c'est-à-dire la dispersion, est, elle aussi, considérablement réduite. Les valeurs réelles des capacités des éléments capacitifs inclus dans un lot de circuits intégrés conforme à l'invention seront donc comprises dans un intervalle plus étroit et sont donc plus facilement prédicables.

L'élément capacitif comporte N-1 capacités disposées en parallèle, chacune constituée par deux couches conductrices séparées par une couche isolante faisant office de diélectrique.

Un premier caisson, ayant un type de conductivité donné, est implanté au sein du substrat de sorte que l'empilement formant le premier élément capacitif soit superposé audit caisson, lequel est relié à la surface du substrat recouverte par ledit empilement via une région de même type de conductivité que le caisson.

Dans ce mode de réalisation, une capacité supplémentaire apparaît donc entre la première couche conductrice et la région reliant la surface du substrat au premier caisson, qui forme ainsi une couche conductrice supplémentaire et introduit une autre étape de fabrication dans le processus de réalisation du circuit intégré, qui réduit encore les influences relatives de chacune des étapes de fabrication sur la valeur réelle de la capacité du premier élément capacitif. La dispersion s'en trouve encore diminuée.

Dans un mode de réalisation avantageux de l'invention, le premier caisson est relié à une borne de référence de potentiel formant la masse du circuit intégré.

L'invention permet de bien maîtriser la capacité existant entre la première couche conductrice et le substrat. Le premier élément capacitif présentera ainsi un meilleur facteur de qualité.

Une variante de l'invention présente un circuit intégré tel que décrit plus haut, caractérisé en ce qu'il inclut en outre un deuxième élément capacitif, destiné à développer entre une première et une deuxième borne une capacité dont la valeur dépend d'une tension de réglage appliquée à la première borne, la deuxième borne du deuxième élément capacitif étant connectée à l'une des bornes du premier élément capacitif.

Cette variante permet de disposer d'une capacité variable, tout en augmentant encore le nombre d'étapes de fabrication nécessaires à la réalisation du circuit intégré. En effet, le deuxième élément capacitif sera le plus souvent un élément actif, faisant appel à des diffusions spécifiques.

Dans un mode de réalisation préféré de invention, un circuit intégré tel que décrit ci-dessus est caractérisé en ce que le deuxième élément capacitif est une diode varicap, construite au-dessus d'un deuxième caisson ayant un type de conductivité donné implanté au sein du substrat, dont une cathode et une anode forment respectivement les première et deuxième bornes.

Dans une autre variante de l'invention, un circuit intégré tel que décrit plus haut comporte en outre un élément inductif dont une première borne est reliée à une borne d'alimentation, et dont une deuxième borne est reliée à la deuxième borne du premier élément capacitif, formant ainsi une borne de sortie d'un oscillateur destiné à délivrer un signal de sortie dont la fréquence dépend de la valeur de la tension de réglage.

Un tel circuit intégré forme un oscillateur commandé en tension, dont l'évolution de la fréquence d'oscillation en fonction de la valeur de la tension de réglage est aisément prédictible, du fait de la réduction de la dispersion rendue possible grâce à l'invention.

Si la présente invention peut être utilisée dans tous types d'applications impliquant des éléments capacitifs dont la valeur doit être connue avec précision, sa mise en oeuvre est particulièrement avantageuse dans des boucles de réception de signaux radioélectriques. L'invention concerne donc également un appareil récepteur de signaux radioélectriques, comportant :
- un système d'antenne et de filtrage, permettant la réception d'un signal radioélectrique dont la fréquence, dite fréquence radio, est sélectionnée au sein d'une gamme de fréquences donnée, et sa transformation en un signal électronique dit signal radio,
- un mélangeur, destiné à recevoir le signal radio et un signal provenant d'un oscillateur local dont la fréquence, dite d'oscillation, est réglable, et à délivrer un signal de sortie ayant une fréquence fixée et égale à la différence entre la fréquence radio et la fréquence d'oscillation, et
- une unité de traitement du signal, destinée à exploiter le signal de sortie du mélangeur, caractérisé en ce que l'oscillateur local est réalisé sous la forme d'un circuit intégré tel que décrit ci-dessus.

L'invention sera mieux comprise à l'aide de la description suivante, faite à titre d'exemple non-limitatif et en regard des dessins annexés, dans lesquels :
- la figure 1 est une vue en coupe d'une partie d'un circuit intégré conforme à un mode de réalisation préféré de l'invention,
- la figure 2 est un schéma électrique représentant une partie d'un circuit intégré conforme à ce mode de réalisation de l'invention,
- la figure 3 est un schéma électrique représentant une partie d'un circuit intégré conforme à une autre variante de l'invention, et
- la figure 4 est un schéma fonctionnel partiel décrivant un appareil récepteur de signaux radioélectriques mettant en oeuvre un circuit intégré conforme à cette variante de l'invention.

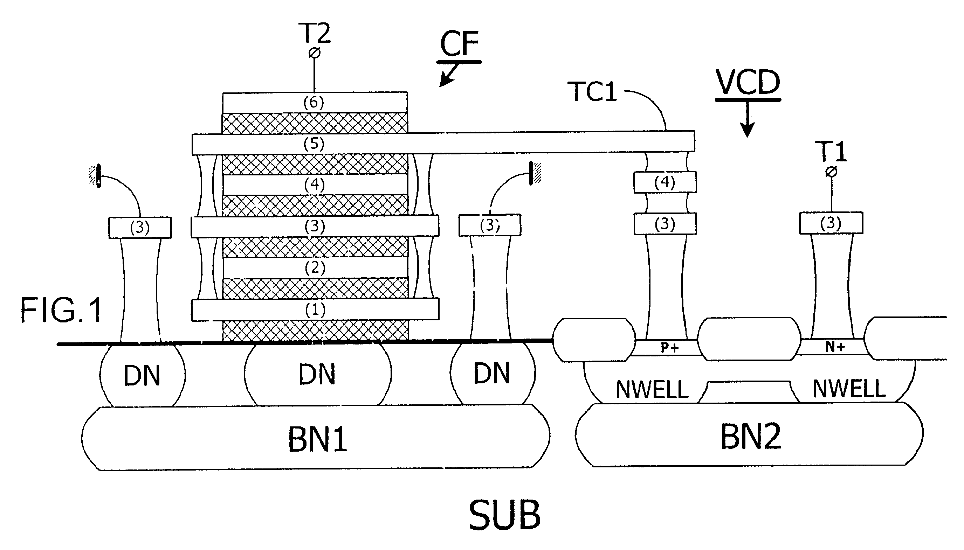

La figure 1 représente sous la forme d'une vue en coupe, une partie d'un circuit intégré comprenant une succession de 6 couches formées de matériaux faiblement résistifs, dites couches conductrices, référencées (1) à (6) en ordre croissant depuis un substrat SUB au-dessus duquel elles sont disposées. Ces couches conductrices (1) à (6) sont séparées deux à deux par des couches de matériau isolant, dites couches isolantes, représentées sous forme de zones hachurées sur cette figure. Les couches (1) et (2) pourront par exemple être réalisées en polysilicium, et les couches (3) à (6) en métal. Le circuit intégré inclut un premier élément capacitif CF présentant entre une première et une deuxième borne TC1 et T2 une capacité de valeur nominale fixe. Cet élément capacitif CF est constitué d'un empilement de plaques conductrices, découpées au sein des couches conductrices et électriquement isolées desdites couches. Le premier élément capacitif CF comprend autant de plaques conductrices que le circuit intégré comprend de couches conductrices, les première et deuxième bornes TC1 et T2 du premier élément capacitif CF étant connectées aux plaques conductrices (1) et (6) formant les extrémités de l'empilement.
Dans le mode de réalisation décrit ici, la ième plaque conductrice du premier élément capacitif CF (pour i=3 à 6) est connectée à la (i-2)ème plaque conductrice dudit élément capacitif, les première et deuxième bornes TC1 et TC2 du premier élément capacitif CF étant respectivement connectées à ses première et sixième plaques conductrices (1) et (6). La présente figure ne décrit que les contacts reliant les première, troisième et cinquième plaques conductrices (1), (3) et (5), et la première borne TC1 du premier élément capacitif CF, les contacts reliant les deuxième, quatrième et sixième plaques conductrices (2), (4) et (6) ne se situant pas dans le même plan de coupe.
L'écart existant entre la valeur réelle et la valeur nominale de la capacité du premier élément capacitif CF inclus dans un tel circuit intégré est égal à la somme des écarts provoqués par chacune des étapes de fabrication nécessaires à la réalisation du circuit intégré. Ainsi, plus le nombre de ces étapes de fabrication est élevé, plus l'influence relative de chacune des étapes sur l'écart entre la valeur réelle et la valeur nominale de ladite capacité est faible. Dans le circuit intégré décrit ici, toutes les couches conductrices sont utilisées pour construire le premier élément capacitif CF, impliquant donc le plus grand nombre possible d'étapes de fabrication liées au découpage desdites couches conductrices. L'influence relative de chacune de ces étapes sur la valeur réelle de l'élément capacitif est donc réduite à son minimum, ce qui permet de diminuer fortement la dispersion.
Dans le mode de réalisation de l'invention décrit ici, un premier caisson BN1, ayant un type de conductivité N, est implanté au sein du substrat SUB de sorte que l'empilement formant le premier élément capacitif CF soit superposé audit caisson BN1, lequel est relié à la surface du substrat SUB recouverte par ledit empilement via une région DN de diffusion N. Le premier caisson BN1 est relié à une borne de référence de potentiel formant la masse du circuit intégré via deux régions DN de diffusion N, reliées chacune par un contact à la troisième couche conductrice (3) qui forme, dans cet exemple, un plan de masse pour le circuit intégré.
En l'absence du premier caisson BN1, une capacité parasite apparaîtrait entre la première couche conductrice (1) et le substrat SUB. Cette capacité parasite serait toutefois dissociée du premier élément capacitif CF et dégraderait le facteur de qualité de celui-ci. L'implantation du caisson BN1 et sa liaison à la surface du substrat SUB via la région de diffusion N présente donc un double avantage : elle introduit de nouvelles étapes de fabrication dans le processus de réalisation du circuit intégré, permettant donc de réduire encore la dispersion, et elle permet d'intégrer la capacité parasite dans la capacité du premier élément capacitif CF, et de maîtriser ladite capacité parasite décrite ci-dessus, en reliant le premier caisson BN1 à la masse du circuit intégré, ce qui améliore le facteur de qualité du premier élément capacitif CF.
Dans le mode de réalisation préféré décrit ici, le circuit intégré inclut en outre un deuxième élément capacitif VCD, destiné à développer entre une première et une deuxième borne une capacité dont la valeur dépend d'une tension de réglage appliquée à la première borne, la deuxième borne du deuxième élément capacitif VCD étant connectée à la première borne, appelée ici TC1, du premier élément capacitif CF. Le deuxième élément capacitif VCD est ici une diode varicap, construite au-dessus d'un deuxième caisson BN2 de type de conductivité N implanté au sein du substrat SUB, dont une cathode et une anode forment respectivement les première et deuxième bornes. La diode varicap VCD est ici réalisée en technologie MOS, ses anode et cathode étant respectivement constituées par des régions de diffusion P+ et N+ implantées à la surface d'un puits NWELL, lui-même disposé au-dessus du deuxième caisson BN2.
L'introduction du deuxième élément capacitif VCD présente deux avantages : elle permet de faire varier la valeur de la capacité de l'ensemble constitué par les premier et deuxième éléments capacitifs CF et VCD disposés en série, et puisqu'elle nécessite de nouvelles étapes de fabrication, a pour effet de diminuer la dispersion.
Par ailleurs, l'association en série du premier élément capacitif CF, dont la capacité a une valeur fixe, avec le deuxième élément capacitif a pour effet de linéariser l'évolution de la valeur de la capacité de l'ensemble ainsi formé en fonction de la valeur de la tension de réglage.
Si, dans cet exemple, le deuxième élément capacitif est réalisé sous la forme d'une diode de type MOS, il est possible de réaliser une telle diode en technologie bipolaire, les avantages décrits ci-dessus étant conservés.

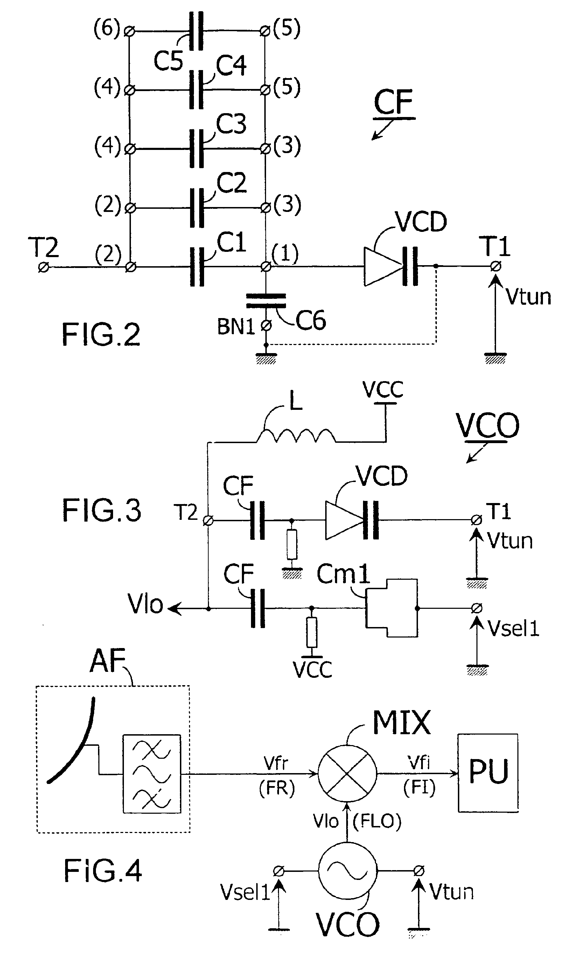

La figure 2 est un schéma électrique équivalent à la partie de circuit intégré décrite ci-dessus. Le premier élément capacitif CF y est représenté comme l'assemblage en parallèle de capacités Ci (pour i=1 à 5) qui apparaissent entre deux couches conductrices successives (i) et (i+1), la couche isolante qui les sépare faisant office de diélectrique. Conformément à la description qui précède, le premier élément capacitif CF comprend de plus une capacité C6 apparaissant entre la première couche conductrice (1) et le premier caisson BN1, lequel est relié à la masse du circuit. Un deuxième élément capacitif VCD, représenté sous la forme d'une diode varicap, est disposé en série avec le premier élément capacitif CF, l'ensemble formant une branche capacitive munie d'une première et d'une deuxième borne T1 et T2. Le deuxième élément capacitif VCD est destiné à développer une capacité dont la valeur dépend d'une tension de réglage Vtun appliquée à la première borne T1.
Cette tension de réglage étant en principe une tension continue, la cathode de la diode varicap constituant le deuxième élément capacitif VCD est, en petits signaux alternatifs, connectée à la masse du circuit, ce qui est équivalent à une connexion entre les premier et deuxième caissons BN1 et BN2 décrits précédemment. Cette connexion virtuelle, représentée sous la forme d'un trait pointillé sur la figure a pour effet d'améliorer le facteur de qualité de la première branche capacitive.

La figure 3 est un schéma électrique d'un circuit intégré conforme à une variante de l'invention qui inclut, en parallèle avec la branche capacitive décrite ci-dessus, un élément inductif L dont une première borne est reliée à une borne d'alimentation VCC, et dont une deuxième borne est reliée à la deuxième borne T2 du premier élément capacitif CF. L'ensemble ainsi obtenu forme un oscillateur contrôlé en tension VCO dont la borne T2 est une borne de sortie, destiné à délivrer un signal de sortie Vlo dont la fréquence dépend de la valeur de la tension de réglage Vtun.
Le deuxième élément capacitif a été jusqu'à présent décrit comme étant réalisé sous la forme d'une diode varicap de type MOS. Il est cependant envisageable de disposer, en parallèle avec la branche capacitive décrite ci-dessus, une deuxième branche capacitive, constituée par un assemblage en série d'un autre élément capacitif CF ayant une capacité de valeur fixe avec une autre diode varicap, réalisée en technologie bipolaire, et également polarisée au moyen de la tension de réglage Vtun. Un tel mode de réalisation, non représenté sur la figure, introduira de nouvelles étapes de fabrication dans le processus de réalisation du circuit intégré et réduira encore la dispersion.
Dans le mode de réalisation décrit ici, une autre branche capacitive, constituée par l'assemblage en série d'un élément capacitif de valeur fixe CF, similaire à ceux décrits plus haut, avec une capacité Cm1 commutable au moyen d'une tension de sélection Vsel1. Cette capacité commutable Cm1 permet d'opérer une sélection de bande. Par ailleurs, étant réalisée sous la forme d'un transistor NMOS, elle introduit de nouvelles étapes de fabrication dans le processus de réalisation du circuit intégré et réduira encore la dispersion. Pour opérer une sélection de bande plus fine, on pourra choisir de connecter une pluralité de telles branches capacitives en parallèle avec la première branche capacitive.
La figure 4 est un schéma fonctionnel décrivant très sommairement un appareil récepteur de signaux radioélectriques, par exemple un radiotéléphone, mettant en oeuvre un circuit intégré conforme à la variante de l'invention précédemment décrite. Cet appareil comporte un système d'antenne et de filtrage AF, permettant la réception d'un signal radioélectrique dont la fréquence FR, dite fréquence radio, est sélectionnée au sein d'une gamme de fréquences donnée, et sa transformation en un signal électronique Vfr appelé signal radio. L'appareil comporte en outre un mélangeur MIX, destiné à recevoir le signal radio Vfr et un signal Vlo provenant d'un oscillateur local VCO dont la fréquence FLO, dite d'oscillation, est réglable, et à délivrer un signal de sortie Vfi ayant une fréquence FI fixée et égale à la différence entre la fréquence radio FR et la fréquence d'oscillation FLO. L'appareil comporte enfin une unité de traitement du signal PU, destinée à exploiter le signal de sortie Vfi du mélangeur MIX. L'oscillateur local VCO est réalisé sous la forme d'un circuit intégré tel que décrit plus haut, destiné à recevoir une tension de réglage Vtun et un signal de sélection Vsel1, dont les valeurs déterminent la valeur de la fréquence d'oscillation FLO, et donc la valeur de la fréquence radio FR du signal radioélectrique sélectionné.

## Revendications

1. Circuit intégré comprenant une succession de couches formées de matériaux faiblement résistifs, dites couches conductrices, séparées deux à deux par des couches de matériau isolant, dites couches isolantes, circuit intégré incluant un premier élément capacitif présentant entre une première et une deuxième borne une capacité de valeur nominale fixe, ledit élément capacitif étant constitué d'un empilement de plaques conductrices, découpées au sein des couches conductrices et électriquement isolées desdites couches, les première et deuxième bornes du premier élément capacitif étant connectées aux plaques conductrices formant les extrémités de l'empilement, le circuit intégré comprenant un substrat servant de support à une succession en alternance de N couches isolantes et de N couches conductrices, numérotées en ordre croissant depuis le substrat, **caractérisé en ce que** la ième plaque conductrice du premier élément capacitif (pour i=3 à N) est connectée à la (i-2)ème plaque conductrice dudit élément capacitif, les première et deuxième bornes du premier élément capacitif étant respectivement connectées à ses première et Nème plaques conductrices,
**caractérisé en ce qu'**un premier caisson, ayant un type de conductivité donné, est implanté au sein du substrat de sorte que l'empilement formant le premier élément capacitif soit superposé audit caisson, lequel est relié à la surface du substrat recouverte par ledit empilement via une région de même type de conductivité que le caisson,
et **en ce que** le premier caisson est relié à une borne de référence de potentiel formant la masse du circuit intégré.

2. Circuit intégré selon la revendication 1 **caractérisé en ce qu'**il inclut en outre un deuxième élément capacitif, destiné à développer entre une première et une deuxième borne une capacité dont la valeur dépend d'une tension de réglage appliquée à la première borne, la deuxième borne du deuxième élément capacitif étant connectée à l'une des bornes du premier élément capacitif.

3. Circuit intégré selon la revendication 2, **caractérisé en ce que** le deuxième élément capacitif est une diode varicap, construite au-dessus d'un deuxième caisson ayant un type de conductivité donné implanté au sein du substrat, dont une cathode et une anode forment respectivement les première et deuxième bornes.

4. Circuit intégré selon la revendication 3, **caractérisé en ce qu'**il comporte en outre un élément inductif dont une première borne est reliée à une borne d'alimentation, et dont une deuxième borne est reliée à la deuxième borne du premier élément capacitif, formant ainsi une borne de sortie d'un oscillateur destiné à délivrer un signal de sortie dont la fréquence dépend de la valeur de la tension de réglage.

5. Appareil récepteur de signaux radioélectriques, comportant :
. un système d'antenne et de filtrage, permettant la réception d'un signal radioélectrique dont la fréquence, dite fréquence radio, est sélectionnée au sein d'une gamme de fréquences donnée, et sa transformation en un signal électronique dit signal radio,
. un mélangeur, destiné à recevoir le signal radio et un signal provenant d'un oscillateur local dont la fréquence, dite d'oscillation, est réglable, et à délivrer un signal de sortie ayant une fréquence fixée et égale à la différence entre la fréquence radio et la fréquence d'oscillation, et
. une unité de traitement du signal, destinée à exploiter le signal de sortie du mélangeur, **caractérisé en ce que** l'oscillateur local est réalisé sous la forme d'un circuit intégré conforme à la revendication 4.

## Claims

1. Integrated circuit comprising a succession of layers formed of slightly resistive materials, called conductive layers, separated in twos by layers of insulating material, called insulating layers, the integrated circuit including a first capacitive element having between a first and a second terminal a capacitor of fixed nominal value, the said capacitive element consisting of a stack of conductive plates, which are cut out within the conductive layers and electrically insulated from the said layers, the first and second terminals of the first capacitive element being connected to the conductive plates forming the ends of the stack, the integrated circuit comprising a substrate used as a base with an alternating succession of N insulating layers and N conductive layers, numbered in ascending order from the substrate,
**characterized in that** the i-th conductive plate of the first capacitive element (for i = 3 to N) is connected to the (i-2)th conductive plate of the said capacitive element, the first and second terminals of the first capacitive element being respectively connected to its first and Nth conductive plates, and **in that** a first box, having a given type of conductivity, is installed within the substrate so that the stack forming the first capacitive element is superposed on the said box, which is connected to the surface of the substrate covered by the said stack via a region of the same type of conductivity as the box, and **in that** the first box is connected to a reference terminal of potential forming the earth of the integrated circuit.

2. Integrated circuit according to Claim 1,
**characterized in that** it also includes a second capacitive element, designed to develop, between a first and a second terminal, a capacitor the value of which depends on a tuning voltage applied to the first terminal, the second terminal of the second capacitive element being connected to one of the terminals of the first capacitive element.

3. Integrated circuit according to Claim 2,
**characterized in that** the second capacitive element is a varicap diode, constructed above a second box having a given type of conductivity installed within the substrate, a cathode and an anode of which respectively form the first and second terminals.

4. Integrated circuit according to Claim 3,
**characterized in that** it also comprises an inductive element a first terminal of which is connected to a power supply terminal, and a second terminal of which is connected to the second terminal of the first capacitive element, thereby forming an output terminal of an oscillator designed to deliver an output signal the frequency of which depends on the value of the tuning voltage.

5. Radioelectric signal receiving device, comprising:
- an antenna and filtering system, allowing the reception of a radioelectric signal the frequency of which, called the radio frequency, is selected from within a given range of frequencies, and its conversion into an electronic signal called a radio signal,
- a mixer, designed to receive the radio signal and a signal originating from a local oscillator the frequency of which, called the oscillation frequency, is adjustable, and to deliver an output signal having a frequency that is fixed and equal to the difference between the radio frequency and the oscillation frequency, and
- a signal-processing unit, designed to exploit the output signal from the mixer,
**characterized in that** the local oscillator is produced in the form of an integrated circuit in accordance with Claim 4.

## Patentansprüche

1. Integrierte Schaltung mit einer Folge von aus schwach resistiven Materialien geformten Schichten, leitende Schichten genannt, paarweise getrennt durch Schichten aus Isoliermaterial, isolierende Schichten genannt, wobei die integrierte Schaltung ein erstes kapazitives Element enthält, das zwischen einer ersten und einer zweiten Klemme eine Kapazität mit festem Nennwert hat, wobei das kapazitive Element aus einem Stapel vom leitenden Platten besteht, die innerhalb der leitenden Schichten ausgeschnitten und elektrisch von den Schichten isoliert sind, wobei die erste und die zweite Klemme des ersten kapazitiven Elements mit den leitenden Platten verbunden sind, die die Enden des Stapels bilden, wobei die integrierte Schaltung ein Substrat enthält, das als Träger für eine Wechselfolge von N isolierenden Schichten und N leitenden Schichten dient, die vom Substrat ausgehend in aufsteigender Reihenfolge nummeriert sind, **dadurch gekennzeichnet, dass** die i-te leitende Platte des ersten kapazitiven Elements (für i = 3 bis N) mit der (i-2)-ten leitenden Platte des kapazitiven Elements verbunden ist, wobei die erste und die zweite Klemme des ersten kapazitiven Elements mit seiner ersten bzw. N-ten leitenden Platte verbunden sind, und dass eine erste Senke mit einem gegebenen Leitfähigkeitstyp so innerhalb des Substrats installiert ist, dass der das erste kapazitive Element bildende Stapel über der Senke angeordnet ist, die mit der von dem Stapel bedeckten Fläche des Substrats über einen Bereich vom gleichen Leitfähigkeitstyp wie die Senke verbunden ist, und dass die erste Senke mit einer Bezugspotentialklemme verbunden ist, die die Masse der integrierten Schaltung bildet.

2. Integrierte Schaltung nach Anspruch 1, **dadurch gekennzeichnet, dass** sie außerdem ein zweites kapazitives Element enthält, das dazu bestimmt ist, zwischen einer ersten und einer zweiten Klemme eine Kapazität zu entwickeln, deren Wert von einer Regelspannung abhängt, die an die erste Klemme angelegt wird, wobei die zweite Klemme des zweiten kapazitiven Elements mit einer der Klemmen des ersten kapazitiven Elements verbunden ist.

3. Integrierte Schaltung nach Anspruch 2, **dadurch gekennzeichnet, dass** das zweite kapazitive Element eine Varicap-Diode ist, die über einer innerhalb des Substrats installierten zweiten Senke mit einem gegebenen Leitfähigkeitstyp aufgebaut ist, von der eine Kathode und eine Anode die erste bzw. die zweite Klemme bilden.

4. Integrierte Schaltung nach Anspruch 3, **dadurch gekennzeichnet, dass** sie außerdem ein induktives Element aufweist, von dem eine erste Klemme mit einer Speiseklemme verbunden ist, und von dem eine zweite Klemme mit der zweiten Klemme des ersten kapazitiven Elements verbunden ist, wodurch eine Ausgangsklemme eines Oszillators gebildet wird, der dazu bestimmt ist, ein Ausgangssignal zu liefern, dessen Frequenz vom Wert der Regelspannung abhängt.

5. Empfängergerät für Funksignale, das aufweist:
- ein Antennen- und Filtersystem, das den Empfang eines funkelektrischen Signals, dessen Frequenz, Funkfrequenz genannt, aus einem gegebenen Frequenzbereich ausgewählt wird, und seine Umwandlung in ein Funksignal genanntes elektronisches Signal ermöglicht,
- eine Mischstufe, die dazu bestimmt ist, das Funksignal und ein von einem lokalen Oszillator stammendes Signal zu empfangen, dessen Frequenz, Schwingungsfrequenz genannt, einstellbar ist, und ein Ausgangssignal zu liefern, das eine Frequenz hat, die festgelegt und gleich der Differenz zwischen der Funkfrequenz und der Schwingungsfrequenz ist, und
- eine Verarbeitungseinheit des Signals, die dazu bestimmt ist, das Ausgangssignal der Mischstufe zu nutzen, **dadurch gekennzeichnet, dass** der lokale Oszillator in Form einer integrierten Schaltung nach Anspruch 4 hergestellt ist.
